# EUROPEAN PATENT APPLICATION

(11) **EP 3 700 034 A1**
(43) Date of publication of application: **26.08.2020**
(21) Application number: 18867670.4
(22) Date of filing: 11.10.2018
(51) Int. Cl.: H02G 3/08, H05K 5/00, H05K 7/14, H01R 13/514, H01R 13/502, H01R 13/73

(54) **ASSEMBLY FOR SECURING REPLACEABLE UNITS TO A WALL**

(30) Priority: 16.10.2017 ES 201731221
(71) Applicant: Simon, S.A.U., 08013 Barcelona (ES)
(72) Inventor: RIQUÈ REBULL, Adrià, 08013 Barcelona (ES); SERRANO PADILLA, Juan Carlos, 08013 Barcelona (ES)
(74) Representative: Balder IP Law, S.L.
(86) International application number: PCT/ES2018/070664
(87) International publication number: WO 2019/077181

(57) **Abstract**

The invention relates to an assembly (1) for securing replaceable units (4) to a wall, said assembly comprising: a rack (2), intended to be directly or indirectly secured to a wall; at least one replaceable unit (4); reversible connection means (5) between the replaceable unit (4) and the rack (2); and a cover frame (3) for the rack (2), intended to be secured to the outside of the rack (2). According to the invention, the reversible connection means (5) consist of at least two pairs of flexible elements (51) and retaining projections (52), and the cover frame (3) has locking tabs (31) provided adjacent to the flexible elements (51), so as to prevent the deformation of the flexible elements (51), and thus to lock the replaceable unit (4) in the rack (2).

## Description

### TECHNICAL FIELD

The present invention relates to an assembly for securing switches, sockets, and the like to a recessed mounting box, and in particular to an assembly that ensures effective securing of the replaceable units.

### BACKGROUND

Assemblies for securing replaceable units to a wall are already known, the assembly comprising:
- a rack, intended to be directly or indirectly secured to a wall;
- at least one replaceable unit, the replaceable unit being for example an electrical device, an actuator, a switch or a lid;
- reversible connection means between the replaceable unit and the rack; and
- a cover frame of the rack intended to be secured to the outside of the rack.

In other words, the assembly constitutes an intermediate structure which enables the replaceable units to be secured, for example, to a box embedded in a wall.

A common manner of implementing the reversible connection means consists of pairs of flexible elements and retaining projections, i.e. the most conventional clipping system. The flexible element is usually a leg or tab which can be considered flexible, which cooperates with a retaining projection. In an assembly such as the one described in the present document, the flexible elements and the retaining projections can be arranged in the rack and at two opposite ends of the replaceable unit, respectively, or, as a likewise viable alternative, the flexible elements and the retaining projections may be arranged at ends of the replaceable unit and in the rack, respectively.

If the general plane of the rack and of the cover lid is considered the main plane, the insertion direction of the replaceable units is the direction perpendicular to said plane.

In order to introduce and secure the replaceable units in the rack, mutual guide means are envisaged, such that the user only needs to correctly arrange the replaceable unit in front of the rack and press in order to overcome the friction forces and the securing force of the elastic elements, which generally will not be that strong, just enough to keep the units correctly positioned, in order to then secure the cover. Although it is not very strong, the retaining force of the assembly of elastic elements and retaining projections must be greater than the elastic force that can be exerted by the wires trapped behind the replaceable units. It also should not be very strong, so that the fitting operation is comfortable and also so that the replaceable units can be easily removed.

Now, it may be that some of the replaceable units, once in use, may be subjected to forces in the introduction direction, although in the opposite direction, that can overcome said retaining force. This may be the case, for example, when one of the replaceable units is a socket, there is a male plug inserted therein, and the friction force between the pins and the holes in the socket is very high, for which reason when the cable is pulled, a force may be produced that is too strong on the replaceable unit, which in this case is a socket.

Sometimes, the assembly may be intended to house many replaceable units, for which reason the rack may be very long. It is also common for both the rack, as well as the lid and the box of the replaceable unit to be made of plastic. Under these circumstances, the deformations of the retaining means will occur much more easily, making the undesired removal of a replaceable unit when a cable is pulled even more likely. This is a situation that must be avoided, because it can further lead to the replaceable unit being able to drag the rear connecting wires with it, leaving them exposed, with the risks that this implies.

### DESCRIPTION OF THE INVENTION

To overcome the drawbacks of the state of the art, the present invention proposes an assembly for securing replaceable units to a wall, the assembly comprising:
- a rack, intended to be directly or indirectly secured to a wall;
- at least one replaceable unit;
- reversible connection means between the replaceable unit and the rack; and
- a cover frame of the rack intended to be secured to the outside of the rack;
wherein the reversible connection means consist of at least two pairs of flexible elements and retaining projections, wherein the flexible elements and the retaining projections are arranged in the rack and at ends of the replaceable unit, respectively, or the flexible elements and retaining projections are arranged at ends of the replaceable unit and in the rack, respectively, wherein the cover frame has locking tabs arranged adjacent to the flexible elements when these are arranged retained by the retaining projections, such that in a configuration wherein the replaceable unit is secured to the rack and the cover frame of the rack is secured to the rack, the locking tabs prevent the deformation of the flexible elements, and therefore lock the replaceable unit in the rack.

Therefore, after clipping the flexible unit or units to the rack, the cover is secured, which will have an additional function of locking the elastic elements. Therefore, the replaceable unit is no longer only retained by the force of the elastic element/retaining projection pair, but now the maximum retaining force is much greater, since the deformation of the flexible elements by the locking tabs is prevented.

In some embodiments, the rack consists of a rack frame wherein an opening is defined for the introduction of the replaceable unit and through a rack rim which extends to the opening on the inside of the rack and which completely or partially defines a housing of the replaceable unit.

Since the rack is a moulded part, this is taken advantage of in order to equip it with different functions, which in this case can be arranged in the rim, which can be given complex shapes.

In some embodiments, the flexible elements and the retaining projections are arranged in the rack rim and at the ends of the replaceable unit, respectively, or the flexible elements and the retaining projections are arranged at the ends of the replaceable unit and in the rack rim, respectively.

Therefore, the present invention envisages, among others, these two configurations of pairs of flexible elements/retaining projections.

In some embodiments, the reversible securing means comprise guide means for inserting the replaceable units into the rack.

This makes it easier for the user to correctly insert and position the replaceable units.

In some embodiments, the guide means have a minimum length comprised between 5 and 10 mm.

By equipping the guide means with a minimum length, this achieves on one hand the improvement of the guiding and, on the other hand the increase in the resistance to torsion of the replaceable units according to an axis contained in the general plane of the rack, perpendicular to the guide direction and which goes from one connecting end of a replaceable unit to the other.

In some embodiments, the guide means comprise two tabs parallel to an insertion direction of the replaceable units into the rack at each of the ends of the replaceable units and the rack comprises guide slots complementary to the tabs arranged in the rim.

This is one implementation of the guide means which can be easily moulded.

In some embodiments, the tabs comprise a lower projection, and the guide slots comprise a transverse retaining edge for the lower projections.

Transverse should be understood as the direction going from one connecting end of each replaceable unit to the other. This pair of lower projection and transverse retaining edge enables the replaceable unit to be better integrated with the rack. For example, if for some reason, a force tends to produce a deformation which tends to move apart the opposite sides of the rack, or of the rim of the rack, these retaining means will oppose said moving apart. Said in another manner, the replaceable unit, thanks to said pair of lower projection and transverse retaining edge, acts as an anchor or brace between the opposite sides of the rack or the rim.

In some embodiments, the replaceable units have a parallelepiped shape, such that a height, a length corresponding to a longitudinal direction and a width corresponding to a transverse direction are defined, the tabs being arranged at the ends according to the longitudinal direction.

In some embodiments, the transition between the rack frame and the rack rim comprises inclined bearing surfaces.

These inclined bearing surfaces, or transition chamfers between rack rim and frame, have the function of enabling a larger angle for inserting a screwdriver, in order to deliberately cause the deformation of the elastic elements and release the replaceable unit. Obviously, it is only necessary to provide these inclined surfaces in positions coinciding with the elastic elements.

In some embodiments, the dimension of the side of the rim wherein the flexible elements are arranged is L, with L being a multiple of the width A of a replaceable unit, such that n=L/A replaceable units can be arranged.

In some embodiments, at least first n flexible elements are arranged on each side of the rim.

In some embodiments, the assembly comprises n-1 additional flexible elements on each side of the rim wherein the flexible elements are arranged, the n-1 additional flexible elements being arranged in intermediate positions between the first n flexible elements, such that intermediate insertion positions of the replaceable units are defined.

In some embodiments, the rack and the cover frame are made of plastic.

Finally, the replaceable units are electrical devices, actuators, switches or lids.

### BRIEF DESCRIPTION OF THE DRAWINGS

As a complement to the description, and for the purpose of helping to make the features of the invention more readily understandable, in accordance with preferred practical exemplary embodiments of the assembly of the invention, said description is accompanied by a set of figures which, by way of illustration and not limitation, represent the following:
Figure 1 is an exploded perspective view of the assembly, with the rack below, the lid above and three replaceable units in the middle. The explosion direction is precisely the insertion direction of the replaceable units into the rack.
Figure 2 shows a perspective view of an assembly provided with only one replaceable unit when it is assembled.
Figure 3 is a cross section of a replaceable unit.
Figure 4 is an upper perspective view of a rack, comprising five elastic elements on each side of the rim.
Figure 5 is a plan view, according to the coupling direction.
Figure 6 is a detail of the elastic element seen according to the introduction direction.
Figure 7 shows a detail of a leg/elastic element in perspective.
Figure 8 shows the cover lid from the side intended to stay hidden, which is the side from which the locking legs or tabs of the elastic elements emerge.
Figure 9 is a very schematic drawing which shows the locking effect of the tabs on the elastic element.

### DESCRIPTION OF A PREFERRED EMBODIMENT OF THE INVENTION

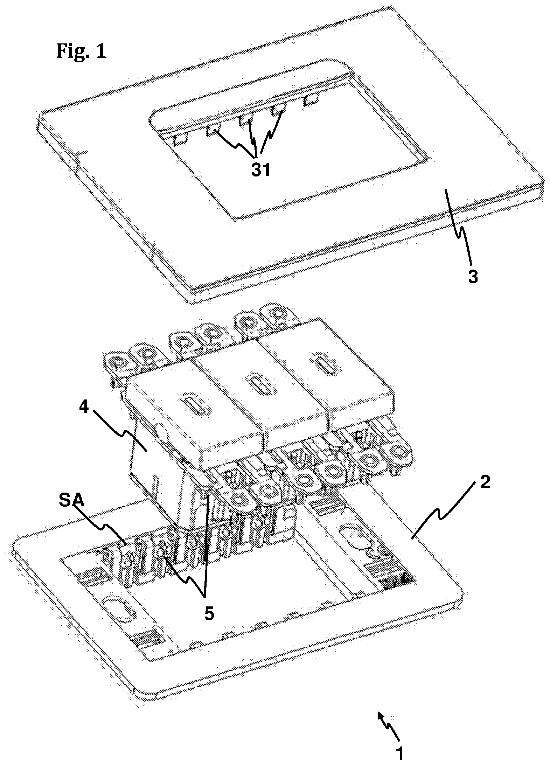

Figure 1 shows an assembly 1 for securing replaceable units 4 to a wall, comprising:
- a rack 2, intended to be directly or indirectly secured to a wall; this is the intermediate structural element between the replaceable unit and the box secured to the wall. This rack 2 consists of a rack frame 21 wherein an opening 22 is defined for the introduction of the replaceable unit 4 and through a rack rim 23 which extends to the opening 22 on the inside of the rack 2 and which completely or partially defines a housing V of the replaceable unit 4.
- at least one replaceable unit 4, which can be a switch, a socket, a lid, a light indicator, a pilot, a wireless signal receiver, etc;
- reversible connection means 5 between the replaceable unit 4 and the rack 2; and
- a cover frame 3 of the rack 2 intended to be secured to the outside of the rack 2.

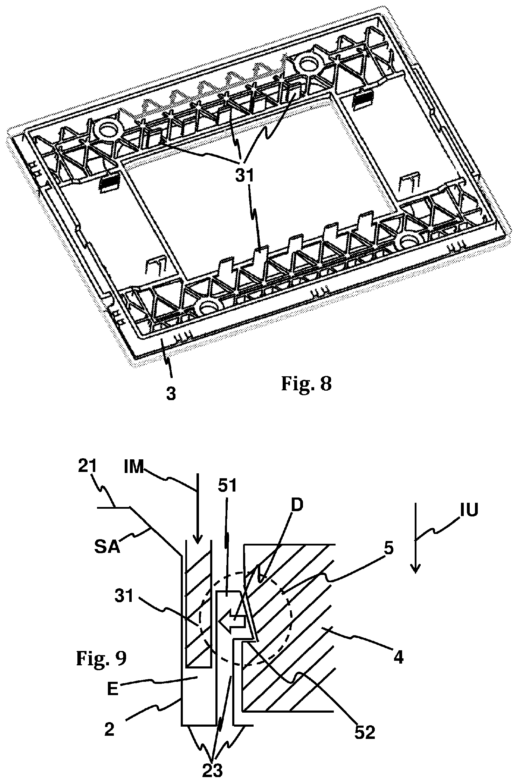

As seen, for example, in figure 9, according to the present invention, the reversible connection means 5 consist of at least two pairs of flexible elements 51 and retaining projections 52. This is one of the most-used clipping mechanisms in many sectors of the art. Apart from the configuration described herein, the present invention can be applied to many other forms of implementation wherein an elastic element collaborates with a retaining projection. In particular, the elastic element can be a leg, a tab, etc., while the retaining projection can be a step, a pin, etc. It is foreseen that the body to which the retaining projection belongs comprises, arranged adjacent to it, a housing for the flexible element 51, such as for example a recess, i.e. a rigid wall housing which prevents the deformation of the flexible element in the envisaged deformation direction, envisaged deformation direction being understood as the one wherein the deformation occurs in the clipping process.

In the embodiment described herein, the flexible elements 51 and the retaining projections 52 are arranged in the rack 2 and at ends of the replaceable unit 4, respectively.

According to the present invention, and as shown in figure 9, the cover frame 3 has locking tabs 31 arranged adjacent to the flexible elements 51 when these are arranged retained by the retaining projections 52, such that in a configuration wherein the replaceable unit 4 is secured to the rack 2 and the cover frame 3 of the rack is secured to the rack 2, the locking tabs 31 prevent the deformation of the flexible elements 51, and therefore lock the replaceable unit 4 in the rack 2.

As seen in figure 8, these tabs 31 are tabs making up the lid or cover frame, for which reason they can be moulded together with it. The effect of the tabs 31 is shown in figure 9. In the absence of these tabs 31, the free end of the elastic element 51 can be moved transversely, a movement shown according to arrow D. This movement will have been produced before the clipping by the movement of the replaceable unit 4 according to the coupling direction IU. Once the replaceable unit 4 has been coupled with the rack 2 (shown in figure 9 by a line 2 which includes the elastic leg 51), the securing of the cover frame 3 to the rack is then performed according to direction IM (parallel to IU), which brings the tabs 31 to occupy the space E adjacent to the elastic element 51, thereby preventing the movement D, and therefore causing the locking of the unit 4 in the rack.

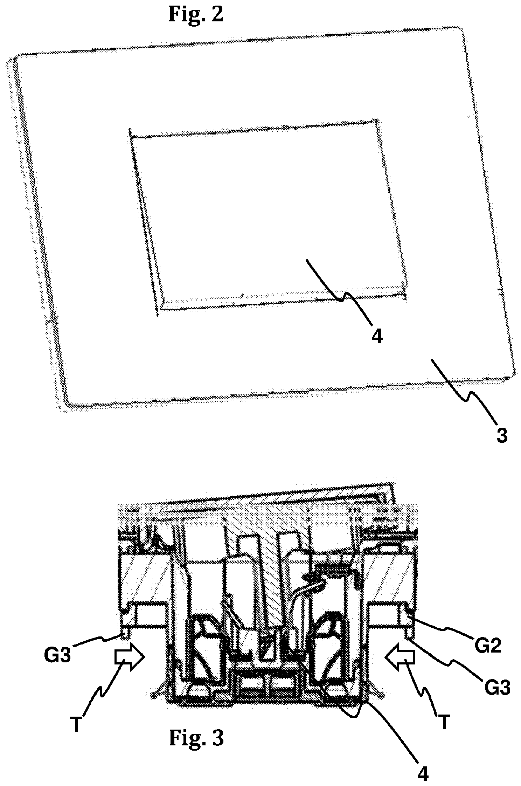

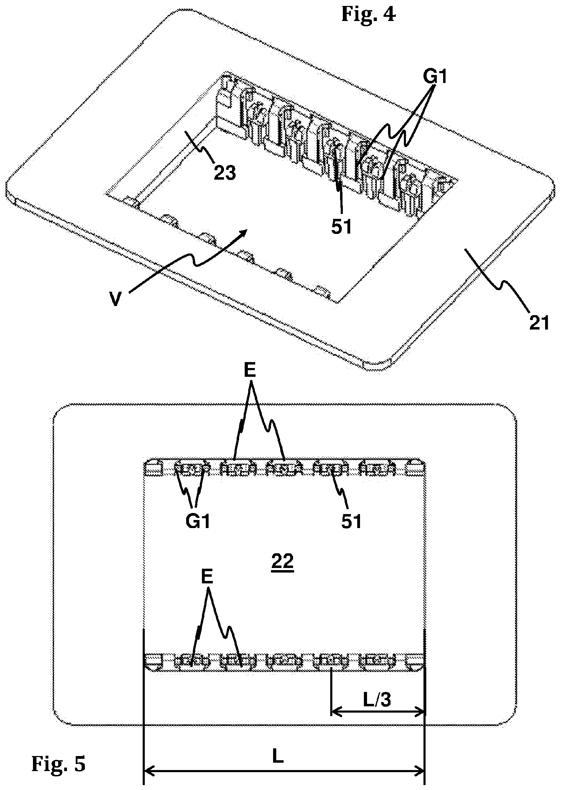

As seen, for example, in figures 3 and 4, the reversible connection means 5 comprise guide means G1, G2 for inserting the replaceable units 4 into the rack 2. The guide means are distributed between the replaceable unit 4 and the rack 2.

According to one embodiment, the guide means G1, G2 have a minimum length comprised between 5 and 10 mm. Guaranteeing a minimum length guarantees a correct guiding and moreover a resistance to the torsion of a replaceable unit with respect to the rack frame.

As seen in figures 3 to 7, the guide means G1, G2 comprise two tabs G2 parallel to an insertion direction of the replaceable units 4 into the rack 2 at each of the ends of the replaceable units 4 and the rack 2 comprises guide slots G1 complementary to the tabs, and arranged in the rim 23.

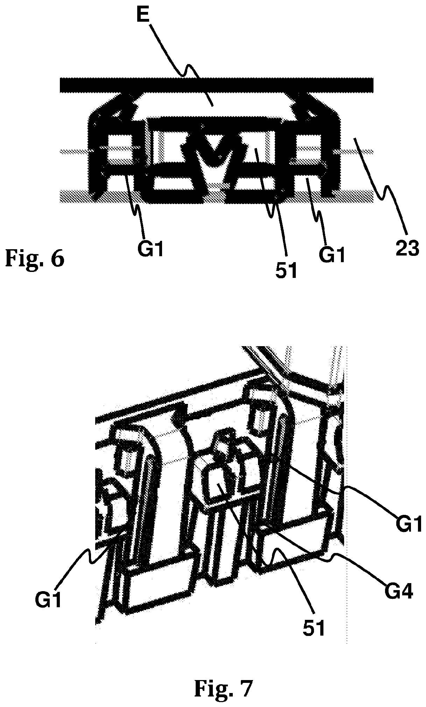

As shown in figures 3 and 7, the tabs G2 comprise a lower projection G3, and the guide slots G1 comprise a transverse retaining edge G4 for the lower projections G3. The cooperation between these lower projections G3 and the transverse retaining edges G4 enable the replaceable unit 4 to exert forces on the rack 2 in the direction indicated by the arrows T.

As seen in figure 3, the replaceable units 4 have a parallelepiped shape, such that a height, a length corresponding to a longitudinal direction and a width corresponding to a transverse direction are defined, the tabs G2 being arranged at the ends according to the longitudinal direction.

As shown in figure 9, the transition between the rack frame 21 and the rack rim 23 comprises inclined bearing surfaces SA.

The dimension of the side of the rim wherein the flexible elements 51 are arranged is L, with L being a multiple of the width A of a replaceable unit 4, such that n=L/A replaceable units 4 can be arranged.

The assembly comprises at least n first flexible elements 51 on each side of the rim wherein the flexible elements 51 are arranged.

The assembly comprises n-1 additional flexible elements 51 on each side of the rim wherein the flexible elements 51 are arranged, the n-1 additional flexible elements 51 being arranged in intermediate positions between the first n flexible elements 51, such that intermediate insertion positions of the replaceable units 4 are defined.

The rack 2 and the cover frame 3 are made of plastic.

The replaceable units are electrical devices, actuators, switches or lids.

In this text, the word "comprises" and its variants (such as "comprising", etc.) should not be understood in an exclusive sense, i.e. they do not exclude the possibility of that which is described including other elements, steps, etc.

Moreover, the invention is not limited to the specific embodiments described herein, but rather encompasses, for example, the variations that a person skilled in the art could make (for example, regarding the choice of materials, dimensions, components, configuration, etc.), within the scope of what may be deduced from the claims.

## Claims

1. An assembly (1) for securing replaceable units (4) to a wall, the assembly (1) comprising:
- a rack (2), intended to be directly or indirectly secured to a wall;
- at least one replaceable unit (4);
- reversible connection means (5) between the replaceable unit (4) and the rack (2); and
- a cover frame (3) of the rack (2) intended to be secured to the outside of the rack (2);
wherein the reversible connection means (5) consist of at least two pairs of flexible elements (51) and retaining projections (52), wherein the flexible elements (51) and the retaining projections (52) are arranged in the rack (2) and at ends of the replaceable unit (4), respectively, or the flexible elements (51) and retaining projections (52) are arranged at ends of the replaceable unit (4) and in the rack (2), respectively, **characterised in that** the cover frame (3) has locking tabs (31) arranged adjacent to the flexible elements (51) when these are arranged retained by the retaining projections (52), such that in a configuration wherein the replaceable unit (4) is secured to the rack (2) and the cover frame (3) of the rack is secured to the rack (2), the locking tabs (31) prevent the deformation of the flexible elements (51), and therefore lock the replaceable unit (4) in the rack (2).

2. The assembly according to claim 1, wherein the rack (2) consists of a rack frame (21) wherein an opening (22) is defined for the introduction of the replaceable unit (4) and through a rack rim (23) which extends to the opening (22) on the inside of the rack (2) and which completely or partially defines a housing (V) of the replaceable unit (4).

3. The assembly according to claim 2, wherein the flexible elements (51) and the retaining projections (52) are arranged in the rack rim (23) and at the ends of the replaceable unit (4), respectively.

4. The assembly according to claim 2, wherein the flexible elements (51) and the retaining projections (52) are arranged at the ends of the replaceable unit (4) and in the rack rim (23), respectively.

5. The assembly according to any of the preceding claims, wherein the reversible connection means (5) comprise guide means (G1, G2) for inserting the replaceable units (4) into the rack (2).

6. The assembly according to claim 5, wherein the guide means (G1, G2) have a minimum length comprised between 5 and 10 mm.

7. The assembly according to claim 2 and claim 5 or 6, wherein the guide means (G1, G2) comprise two tabs (G2) parallel to an insertion direction of the replaceable units (4) into the rack (2) at each of the ends of the replaceable units (4) and the rack (2) comprises guide slots (G1) complementary to the tabs arranged in the rim (23).

8. The assembly according to claim 7, wherein the tabs (G2) comprise a lower projection (G3), and the guide slots (G1) comprise a transverse retaining edge (G4) for the lower projections (G3).

9. The assembly according to claim 7 or 8, wherein the replaceable units (4) have a parallelepiped shape, such that a height, a length corresponding to a longitudinal direction and a width corresponding to a transverse direction are defined, the tabs (G2) being arranged at the ends according to the longitudinal direction.

10. The assembly according to claim 3 and any claim dependent thereon, wherein the transition between the rack frame (21) and the rack rim (23) comprises inclined bearing surfaces (SA).

11. The assembly according to claim 2 and any claim depending on it, wherein the dimension of the side of the rim wherein the flexible elements (51) are arranged is L, with L being a multiple of the width A of a replaceable unit (4), such that n=L/A replaceable units (4) can be arranged.

12. The assembly according to claim 11, comprising at least n first flexible elements (51) on each side of the rim wherein the flexible elements (51) are arranged.

13. The assembly according to claim 11, comprising n-1 additional flexible elements (51) on each side of the rim wherein the flexible elements (51) are arranged, the n-1 additional flexible elements (51) being arranged in intermediate positions between the first n flexible elements (51), such that intermediate insertion positions of the replaceable units (4) are defined.

14. The assembly according to any of the preceding claims, wherein the rack (2) and the cover frame (3) are made of plastic.

15. The assembly according to any of the preceding claims, wherein the replaceable units are electrical devices, actuators, switches or lids.
